# EUROPEAN PATENT SPECIFICATION

(11) **EP 1 865 761 B1**
(45) Date of publication and mention of the grant of the patent: **16.05.2012**
(21) Application number: 07010993.9
(22) Date of filing: 04.06.2007
(51) Int. Cl.: H05K 9/00

(54) **Electronic appliance**
Elektronisches Gerät
Appareil électronique

(30) Priority: 06.06.2006 JP 2006156855
(43) Date of publication of application: 12.12.2007
(73) Proprietor: Sharp Kabushiki Kaisha, Osaka-shi, Osaka 545-8522 (JP)
(72) Inventor: Higashino, Shinya, Higashihiroshima-shi Hiroshima (JP)
(74) Representative: Müller - Hoffmann & Partner

(56) References cited:
- EP-A- 0 482 460
- EP-A- 1 422 271
- JP-A- 11 185 991
- US-A- 5 175 033

## Description

### BACKGROUND OF THE INVENTION

### Field of the Invention

The present invention relates to electronic appliances, and more particularly to electronic appliances that are so structured as to be resistant to static electricity.

### Description of Prior Art

In an electronic appliance such as a cellular phone or PDA (personal digital assistant), when static electricity that builds up as the appliance is used is applied to it and enters its casing through a gap or the like in it, the static electricity conducts to electronic components mounted on a circuit board inside the appliance, and may cause malfunctioning of electronic circuits and breakdown of electronic components. To prevent this, conventionally, protective components such as diodes and resistors are fitted on the circuit board for protection against static electricity.

### PROBLEMS TO BE SOLVED BY THE INVENTION

Inconveniently, this conventional mode of protecting against static electricity involves fitting extra protective components, and thus has the disadvantage of increasing the number of electronic components mounted on a circuit board.

Under this background, there have conventionally been proposed electronic appliances that can be protected against static electricity without increasing the number of electronic components mounted on a circuit board. Examples of such electronic appliances are disclosed in, for example, JP-A-H11-185991 and JP-A-S61-292879.

JP-A-H11-185991 mentioned above proposes an electronic appliance comprising a circuit board having electronic components mounted thereon and a display panel, wherein a transparent electrically conductive sheet is laid over the surface of the display panel, and this transparent electrically conductive sheet is connected to a grounded portion of the circuit board with an electrically conductive member such as a coil spring. This makes it possible to achieve protection against static electricity without increasing the number of electronic components mounted on the circuit board.

On the other hand, JP-A-S61-292879 mentioned above proposes an electronic appliance wherein a pattern of electrically conductive ink is printed on the surface of a panel member formed of plastic, and the printed pattern is electrically connected to a metal chassis or the like. This too makes it possible to achieve protection against static electricity without increasing the number of electronic components mounted on a circuit board.

These conventional technologies, however, have the following disadvantages. The electronic appliance proposed in JP-A-H11-185991 mentioned above requires that a transparent electrically conductive sheet be laid over the display panel, and thus requires an extra space corresponding to the thickness of the transparent electrically conductive sheet inside the appliance. This makes it more difficult to secure a space in which to mount components inside the appliance, and thus makes it more difficult to make the appliance compact and slim. Moreover, with the electronic appliance proposed in JP-A-H11-185991, the transparent electrically conductive sheet laid over the display panel certainly offers the effect of shielding off noise generated from around the display panel, using a transparent electrically conductive sheet in a wireless communication appliance such as a cellular phone that generates radiowaves has, exactly because of the shielding effect of the sheet, the disadvantage of changing the wireless communication characteristics of the appliance.

On the other hand, with the electronic appliance proposed in JP-A-S61-292879 mentioned above, the electrically conductive ink, when connected to a metal chassis or the like, exerts a shielding effect, and thus the printed pattern of electrically conductive ink has the disadvantage of acting as a shield. Thus, as with the electronic appliance proposed in JP-A-H11-185991, using electrically conductive ink in a wireless communication appliance (electronic appliance) such as a cellular phone that generates radiowaves in an attempt to protect it against static electricity has the disadvantage of changing the wireless communication characteristics of the appliance.

An object of the present invention is to provide an electronic appliance that permits protection of election components against static electricity with a minimum change in the wireless communication characteristics of the appliance and that achieves it with a minimum increase in the number of electronic components mounted on a base board to permit the appliance to be made compact and slim.

EP 1 422 271 A1 describes shielding materials for the realization of coatings of electrostatic protection of paintings type or varnish containing such an additive, in particular for use in the aircraft industries.

The problem is solved by an electronic appliance according to claim 1.

### MEANS FOR SOLVING THE PROBLEM

To achieve the above object, according to a first aspect of the invention, a portable electronic appliance for wireless communication is provided with: a base board having electronic components mounted thereon; and a painted member painted with an antistatic paint that discharges static electricity in order to protect the electronic components from static electricity but is electrically non-conductive in order to minimize the change in the wireless communication characteristics of the electronic appliance.

In the electronic appliance according to the first aspect of the invention, thanks to the above-described painted member painted with the antistatic paint that discharges static electricity, in a case where part of the painted member painted with the antistatic paint is connected to a grounded portion, static electricity that builds up during use can be diverted across the part of the painted member painted with the antistatic paint to the grounded portion. Thus, static electricity that builds up during use can be prevented from conducting to electronic components on the base board. In this way, the electronic components mounted on the base board can be protected from static electricity, and thus, the painted member painted with the antistatic paint helps achieve protection against static electricity in the appliance. In addition, since the antistatic paint is electrically non-conductive, it does not exert, even in a case where the part painted with the antistatic paint is connected to a grounded portion, a shielding effect as exerted by a transparent electrically conductive sheet or an electrically conductive paint such as an electrically conductive ink. This helps minimize the change in the wireless communication specifications of the appliance. Hence, even in a wireless communication appliance such as a cellular phone that generates radiowaves, the painted member painted with the antistatic paint helps achieve protection against static electricity in the appliance.

Moreover, in the electronic appliance according to the first aspect of the invention, the painted member painted with the antistatic paint helps achieve protection of the electronic components against static electricity without requiring mounting of extra protective components (electronic components) such as diodes and resistors on the base board. This helps minimize the increase in the number of electronic components mounted on the base board, and thus helps secure a sufficiently large component mounting area on the base board. In addition, the painted member painted with the antistatic paint that discharges static electricity helps achieve protection against static electricity in the appliance with a paint that can be made thinner than a sheet member such as a transparent electrically conductive sheet. This makes it easy to secure inside the appliance a space in which to mount components, and thus permits the appliance to be made compact and slim.

The electronic appliance according to the first aspect of the invention described above may be further provided with: a display panel for displaying information; and a protective panel for protecting the display panel. Moreover, the painted member is, for example, the protective panel painted with the antistatic paint.

In this case, preferably, the electronic appliance is an electrically conductive member that is grounded. Moreover, as a result of the protective panel being painted with the antistatic paint, the protective panel has formed thereon a discharge path for preferentially discharging static electricity. Furthermore, the discharge path is connected to or placed close to the electrically conductive member. With this structure, static electricity that builds up during use can be diverted across the discharge path formed on the protective panel via the electrically conductive member to a grounded portion. Thus, static electricity can easily be prevented from conducting to electronic components on the base board. In this way, the electronic components mounted on the base board can easily be protected against static electricity. Even in a case where the discharge path is placed close to the electrically conductive member, static electricity can be passed, by secondary discharge, across the discharge path to the electrically conductive member. In a case where the discharge path is connected to the electrically conductive member, static electricity can naturally be passed across the discharge path to the electrically conductive member.

In the above-described structure including the protective panel, preferably, the antistatic paint contains an electrically insulating base substance and an electrically conductive substance, and the antistatic paint is made electrically non-conductive as a result of the electrically conductive substance being discontinuously dispersed in the electrically insulating base substance. With this structure, the antistatic paint can be made electrically non-conductive but simultaneously capable of passing static electricity by secondary discharge. Specifically, with the electrically conductive substance discontinuously dispersed in the electrically insulating base substance, the electrically insulating base substance is present between discontinuous parts of the electrically conductive substance, and this makes electrical conduction impossible; here, even though the electrically insulating base substance is embedded in the electrically conductive substance, so long as different parts of the electrically conductive substance are close enough together, static electricity passes by secondary discharge.

In this case, preferably, the antistatic paint contains the highest possible content of the electrically conductive substance within the range in which the antistatic paint remains electrically non-conductive. With this structure, the distances between different parts of the electrically conductive substance in the base substance can be made smaller, and this makes secondary discharge of static electricity between different parts of the electrically conductive substance easier. Thus, static electricity can easily be passed across the part of the protective panel painted with the antistatic paint. Hence, static electricity that builds up during use can easily be diverted to a grounded portion.

In the above-described structure in which the antistatic paint contains an electrically conductive substance, preferably, the electrically conductive substance is a metal substance. With this structure, between different parts of the metal substance that are discontinuously dispersed in the base substance, static electricity can easily be discharged by secondary discharge. Thus, static electricity can easily be passed across the part painted with the antistatic paint.

In the above-described structure including the protective panel, preferably, the protective panel has the inner surface thereof painted with the antistatic paint. With this structure, the protective panel can be fitted to the appliance such that the part of the former painted with the antistatic paint is located inside the latter. Thus, the part can easily be connected to or placed close to the electrically conductive member that is grounded. In addition, the user can be prevented from touching the part painted with the antistatic paint, and thus the paint can be prevented from being removed as a result of the user touching the part painted with the antistatic paint.

In the above-described structure including the electrically conductive member that is grounded, the base board may have a grounded portion so that the electrically conductive member is grounded by being connected to or placed close to the grounded portion of the base board.

### BRIEF DESCRIPTION OF THE DRAWINGS

Fig. 1 is an overall perspective view of a cellular phone according to a first embodiment of the invention;
Fig. 2 is a schematic plan view of a display portion of the cellular phone according to the first embodiment of the invention;
Fig. 3 is a cross-sectional view along line 100-100 in Fig. 2;
Fig. 4 is a cross-sectional view of a protective panel along line 200-200 in Fig. 2;
Fig. 5 is a conceptual cross-sectional view of an antistatic paint film in the cellular phone according to the first embodiment of the invention;
Fig. 6 is a schematic plan view of a display portion of a cellular phone according to a second embodiment of the invention; and
Fig. 7 is a cross-sectional view along line 300-300 in Fig. 6.

### DETAILED DESCRIPTION OF PREFERRED EMBODIMENTS

Hereinafter, the present invention will be described specifically by way of embodiments with reference to the accompanying drawings. The first and second embodiments presented below both deal with cases in which the invention is applied to a cellular phone as an example of an electronic appliance.

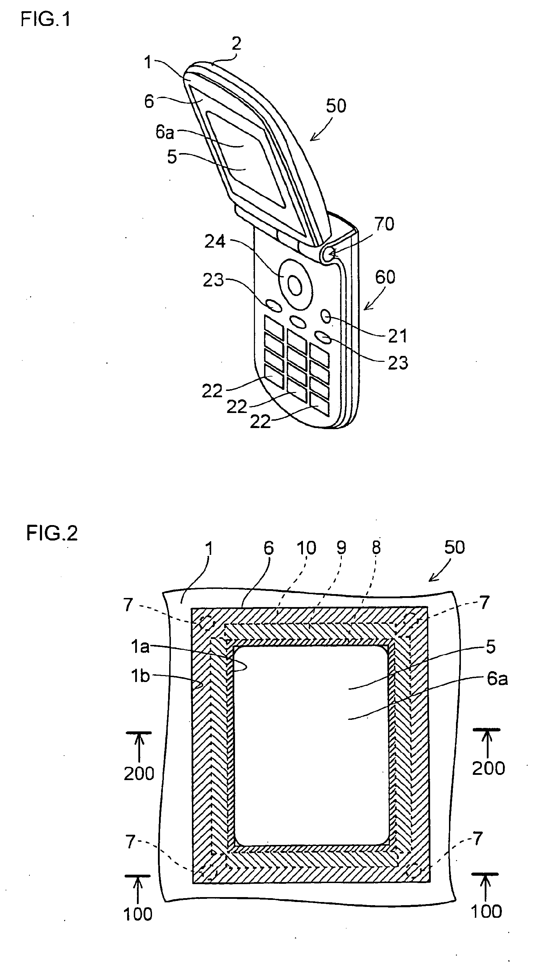

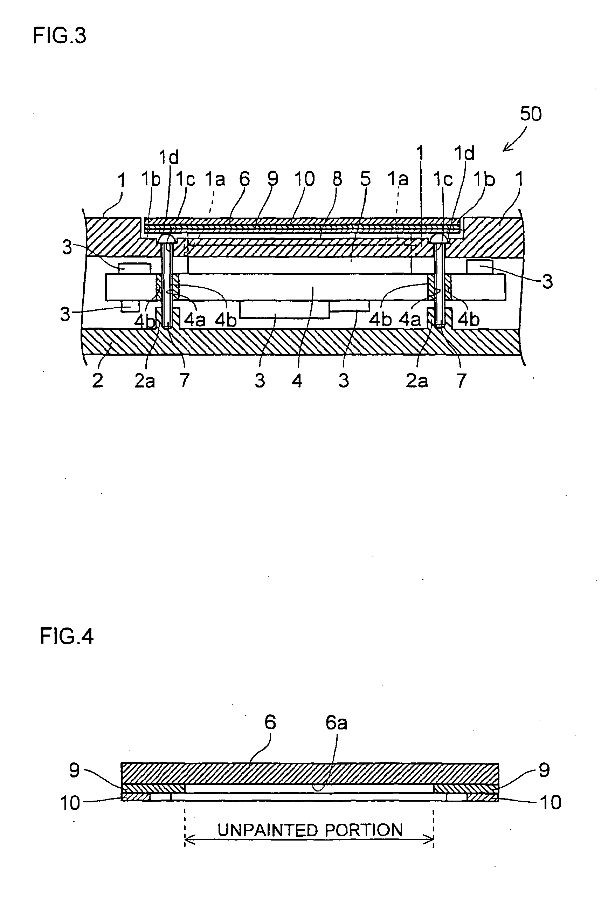

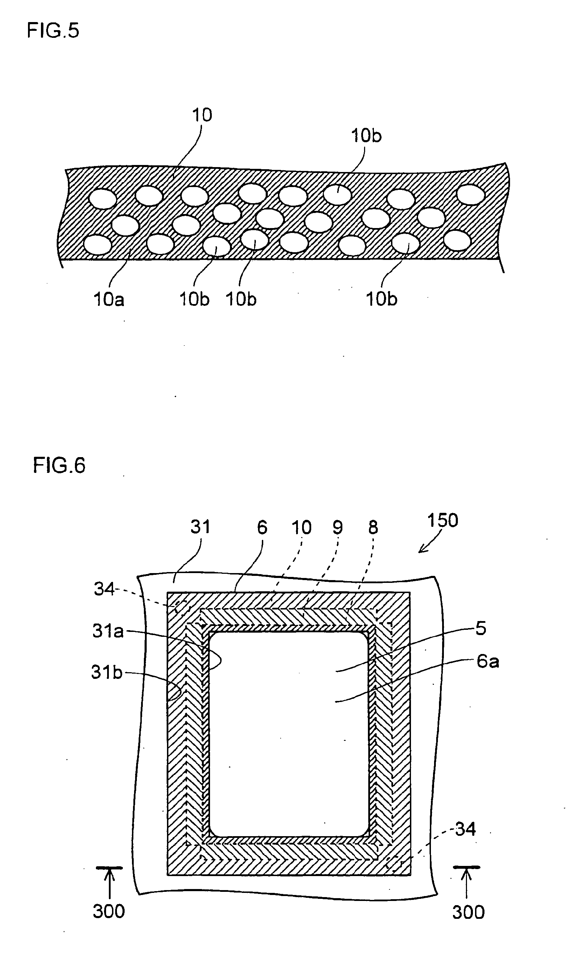

**First Embodiment:** Fig. 1 is an overall perspective view of a cellular phone according to a first embodiment of the invention. Fig. 2 is a schematic plan view of a display portion of the cellular phone according to the first embodiment of the invention. Fig. 3 is a cross-sectional view along line 100-100 in Fig. 2. Fig. 4 is a cross-sectional view of a protective panel along line 200-200 in Fig. 2. Fig. 5 is a conceptual cross-sectional view of an antistatic paint film in the cellular phone according to the first embodiment of the invention. Now, with reference to Figs. 1 to 5, the cellular phone according to the first embodiment of the invention will be described.

As shown in Fig. 1, the cellular phone according to the first embodiment is composed of a display portion 50 and an operation portion 60 that are foldably coupled together with a hinge portion 70. On the operation portion 60 are arranged a power key 21 for turning the power on and off, a plurality of numerical keys 22 for entering telephone numbers etc., a plurality of operation keys 23, and a cross key 24. On the display portion 50 is arranged a liquid crystal display panel 5 for displaying character-based information such as telephone numbers as well as image-based information.

As shown in Figs. 2 and 3, the display portion 50 is provided with a top casing 1, a bottom casing 2, a circuit board 4 having electronic components 3 mounted thereon, the liquid crystal display panel 5, and a protective panel 6. Here, the circuit board 4 is one example of what is called "base board" in the present invention, and the liquid crystal display panel 5 is one example of what is called "display panel" in the present invention.

As shown in Figs. 2 and 3, the top casing 1 has an opening 1a, and has a recess 1b around the opening 1a. In the recess 1b, a plurality of (four) through holes 1c, into which metal screws 7 are inserted, are formed at predetermined intervals. Around each of the through holes 1c, a recess 1d is formed with a diameter larger than the head of the screws 7. On the bottom casing 2, at positions that face the through holes 1c in the top casing 1 when the top and bottom casings 1 and 2 are put together, bosses 2a are formed each having a screw hole. In the circuit board 4 having the electronic components 3 mounted thereon, through holes 4a are formed through which the screws 7 is inserted. Here, the metal screws 7 are one example of what is called "electrically conductive member" in the present invention.

As shown in Fig. 3, the liquid crystal display panel 5 is arranged on the top side of the circuit board 4, in an area facing the opening 1a in the top casing 1. Above the liquid crystal display panel 5, the protective panel 6 is fitted, which is formed of transparent acrylic resin. The protective panel 6 is fitted in the recess 1b in the top casing 1, and serves to protect the display surface of the liquid crystal display panel 5. The protective panel 6 is fitted on the top casing 1 such that the front surface (facing outward) of the protective panel 6 is substantially flush with the outer surface of the top casing 1. Between the protective panel 6 and the liquid crystal display panel 5, a frame-shaped sponge member 8 is fitted. The sponge member 8 prevents entry of foreign matter between the liquid crystal display panel 5 and the protective panel 6.

The top casing 1, the circuit board 4, and the bottom casing 2 are put together in this order, and the screws 7 inserted through the through holes 1c in the top casing 1 are put through the through holes 4a in the circuit board 4 and fixed to the bosses 2a on the bottom casing 2. Here, the recesses 1d around the through holes 1c in the top casing 1 are so formed that the heads of the screws 7 protrude from the floor surface of the recess 1b around the opening 1a.

In the first embodiment, on the inner circumferential surfaces of the through holes 4a in the circuit board 4, grounded portions 4b are formed that are kept at the ground-side potential of the supplied electric power. Thus, with the screws 7 put through the through holes 4a in the circuit board 4, the grounded portions 4b make contact with or come close to the screws 7, and thereby permit the screws 7 to be grounded.

As shown in Figs. 3 and 4, in the first embodiment, on the surface of the protective panel 6 is formed, in order going away therefrom, a panel coloring paint film 9 for giving the protective panel 6 a desired color and an antistatic paint film 10 for protection against static electricity. The panel coloring paint film 9 is formed by painting a panel coloring paint that gives the protective panel 6 the color thereof. The antistatic paint film 10 is formed by painting an antistatic paint that lets static electricity pass across it but is electrically non-conductive. In the first embodiment, used as the antistatic paint is a paint for metallic coloring, such as a mirror ink.

As shown in Fig. 5, the antistatic paint has a metal powder 10b, as an electrically conductive substance, discontinuously dispersed in an electrically non-conductive base substance 10a. Thus, the electrically non-conductive base substance 10a is present between dispersed parts of the metal powder 10b. This gives the antistatic paint so high a resistance that the antistatic paint film 10 formed by painting it is electrically non-conductive. On the other hand, in the base substance 10a, dispersed parts of the metal powder 10b remain close enough together to pass (discharge) static electricity by secondary discharge. The antistatic paint contains the highest possible content of the metal powder 10b within the range in which the antistatic paint remains electrically non-conductive.

As shown in Figs. 2 and 4, in the first embodiment, the panel coloring paint film 9 is formed over a predetermined area on the surface of the protective panel 6, excluding where a display window 6a (unpainted portion) is located to permit what is displayed on the liquid crystal display panel 5 to be viewed. The antistatic paint film 10 is formed over that predetermined area on the top surface of the panel coloring paint film 9. The antistatic paint film 10 thus forms a discharge path across which static electricity preferentially passes (is discharged).

As shown in Fig. 3, in the first embodiment, the panel coloring paint film 9 and the antistatic paint film 10 are formed on the inner surface (facing the inside of the appliance) of the protective panel 6. Thus, when the protective panel 6 is fitted to the top casing 1, the heads of the screws 7 protruding from the floor surface of the recess 1b around the opening 1a make contact with or come close to the antistatic paint film 10 on the protective panel 6. Even in a case where the antistatic paint film 10 is simply located close to the heads of the screws 7, static electricity can be passed, by secondary discharge, to the screws 7, which are grounded.

As described above, in the first embodiment, the antistatic paint film 10 on the protective panel 6 and the heads of the grounded screws 7 are kept in contact with or close to each other. Thus, static electricity that builds up during use can be diverted across the antistatic paint film 10 formed on the protective panel 6 via the metal screws 7 to the grounded portions 4b of the circuit board 4. In this way, static electricity can be prevented from conducting to the electronic components 3 on the circuit board 4. Thus, even if static electricity is applied to the protective panel 6, the electronic components 3 mounted on the circuit board 4 can be protected from static electricity.

In the first embodiment, the antistatic paint film 10 is formed by painting the surface of the protective panel 6 with an antistatic paint that is electrically non-conductive. Thus, the antistatic paint film 10 on the protective panel 6 does not act as a shield as does a transparent electrically conductive sheet or an electrically conductive paint such as an electrically conductive ink. This helps minimize the change in the wireless communication specifications of the appliance. Hence, even in a wireless communication appliance such as a cellular phone that generates radiowaves, fitting it with the protective panel 6 having the antistatic paint film 10 formed thereon helps achieve protection against static electricity in the appliance.

In the first embodiment, the antistatic paint contains, as an electrically conductive substance, the highest possible content of the metal powder 10b within the range in which the antistatic paint remains electrically non-conductive. This helps make the distances between discontinuous parts of the metal powder 10b dispersed in the base substance 10a as small as possible, and thus helps make secondary discharge of static electricity between discontinuous parts of the metal powder 10b easier. Thus, static electricity can easily be passed across the antistatic paint film 10 formed on the surface of the protective panel 6. Hence, even if static electricity builds up during use, it can easily be diverted via the screws 7, which are in contact with or close to the antistatic paint film 10, to the grounded portions 4b of the circuit board 4.

In the first embodiment, by forming the antistatic paint film 10 on the surface of the protective panel 6, it is possible to achieve protection against static electricity without a need to mount extra protective components (electronic components 3) such as diodes and resistors on the circuit board 4. This helps minimize the increase in the number of electronic components 3 mounted on the circuit board 4, and helps secure a sufficient mounting area on the circuit board 4.

In the first embodiment, the protective panel 6 painted with the antistatic paint helps achieve protection against static electricity in the appliance with a paint that can be made thinner than a sheet member such as a transparent electrically conductive sheet. This makes it easy to secure inside the appliance a space in which to mount components, and thus permits the appliance to be made compact and slim.

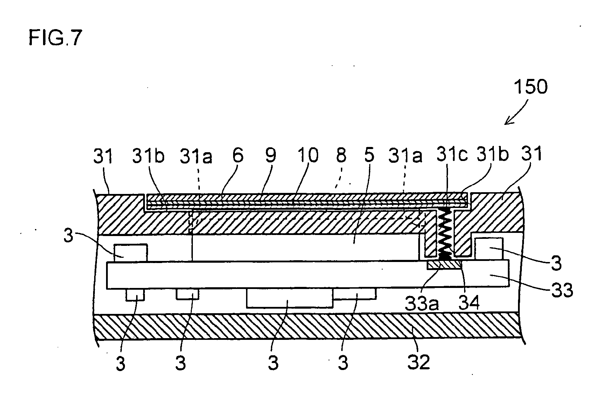

**Second Embodiment:** Fig. 6 is a schematic plan view of a display portion of a cellular phone according to a second embodiment of the invention. Fig. 7 is a cross-sectional view along line 300-300 in Fig. 6. Now, with reference to Figs. 6 and 7, the second embodiment will be described, which differs from the first embodiment described above in that, instead of the metal screws 7 (see Fig. 3), metal coil springs 34 are used in the display portion 150. Except for the top casing 31, the bottom casing 32, the circuit board 33, and the coil springs 34, the structure here is the same as in the first embodiment described above, and therefore no overlapping explanations will be repeated.

As shown in Fig. 7, in the cellular phone according to the second embodiment, the top casing 31, the circuit board 33, and the bottom casing 32 are put together in this order. As shown in Figs. 6 and 7, as in the first embodiment, the top casing 31 has an opening 31 a, and has a recess 31b around the opening 31a. As shown in Fig. 7, at predetermined positions in the recess 31b, through holes 31c are formed vertically (in the direction of the thickness of the top casing 31). In an area on the circuit board 33 that faces the through holes 31c in the top casing 31 when the former is fitted to the latter, a grounded portion 33a is provided that is kept at the ground-side potential of the supplied electric power.

Into the through holes 31c in the top casing 31, the coil springs 34 are inserted. The length of the coil springs 34 is greater than the depth of the through holes 31c, and thus, when the coil springs 34 are inserted into the through holes 31 c, the former protrude out of the latter. Thus, when the protective panel 6 having the antistatic paint film 10 formed on the inner surface thereof is fitted to the top casing 31, the coil springs 34, at one end thereof, make contact with the antistatic paint film 10 on the protective panel 6, and in addition the coil springs 34, at the other end thereof, make contact with the grounded portion 33a of the circuit board 33. That is, in the second embodiment, the antistatic paint film 10 on the protective panel 6 and the grounded portion 33a of the circuit board 33 are connected together by the coil springs 34.

In the second embodiment, as distinct from the first embodiment, the coil springs 34, instead of the screws 7 (see Fig. 3), are used to connect the antistatic paint film 10 on the protective panel 6 and the grounded portion 33a of the circuit board 33 together. Accordingly, on the bottom casing 32, no bosses 2a (see Fig. 3) are formed that have screw holes to permit the screws 7 to be fixed thereto.

As described above, in the second embodiment, the antistatic paint film 10 on the protective panel 6 and the grounded portion 33a of the circuit board 33 are connected together by the coil springs 34 so that static electricity that builds up during use is diverted across the antistatic paint film 10 on the protective panel 6 to the grounded portion 33a of the circuit board 33. Thus, static electricity is prevented from conducting to the electronic components 3 on the circuit board 33. Hence, even if static electricity is applied to the protective panel 6, the electronic components 3 mounted on the circuit board 33 are protected from static electricity. Here, the circuit board 4 is one example of what is called "base board" in the present invention, and the coil springs 34 are one example of what is called "electrically conductive member" in the present invention.

The other benefits of the second embodiment are the same as those of the first embodiment described previously.

It should be understood that all the embodiments specifically described in the present specification are merely examples of, and therefore in no way intended to limit, how the present invention is practiced. The scope of the present invention should be defined in accordance with the appended claims rather than the embodiments presented above, and should be understood to cover any modifications and variations made within the spirit and scope equivalent to those of claims.

For example, although the first and second embodiments described above deal with examples where the invention is applied to a cellular phone, this is in no way intended to limit the application of the invention; the invention may also be applied to electronic appliances other than a cellular phone, such as PHS (personal handy-phone system) phones, PDAs, and electronic still camera. The electronic appliances to which the invention is applied may or may not be portable.

Although the first and second embodiments described above deal with examples where an antistatic paint is applied to the surface of a protective panel, this is in no way intended to limit how the application is practiced; instead, the antistatic paint may be applied to any member other than a protective panel, such as the casing.

Although the first and second embodiments described above deal with examples where an antistatic paint is applied to a protective panel for protecting the surface of a liquid crystal display panel, this is in no way intended to limit how the application is practiced; instead, the antistatic paint may be applied to any member other than a protective panel for protecting a liquid crystal display panel. In that case, the invention can be applied to an electronic appliance that has no display panel.

Although the first and second embodiments described above deal with examples where a liquid crystal display panel is used as one example of a display panel, this is in no way intended to limit how the application is practiced; instead, any display panel other than a liquid crystal display panel may be used, such as an LED (light-emitting diode) display, an EL (electroluminescence) display, a PDP (plasma display panel), and a CRT (cathode ray tube).

Although the first and second embodiments described above deal with examples where an antistatic paint is used that contains the highest possible content of a metal powder within the range in which the antistatic paint remains electrically non-conductive, this is in no way intended to limit how the application is practiced; instead, any antistatic paint may be used that contains less than the highest possible content of a metal powder within the range in which the antistatic paint remains electrically non-conductive, so long as the antistatic paint discharges static electricity but is electrically non-conductive. In that case, it is preferable that the content of a metal powder in the antistatic paint be higher than the content of an electric conductive substance in a panel coloring paint that gives a protective panel the color thereof.

Although the first and second embodiments described above deal with examples where an antistatic paint is used that contains a metal powder as an electrically conductive substance, this is in no way intended to limit how the application is practiced; instead, any antistatic paint may be used that contains any other electrically conductive substance such as graphite or carbon.

Although the first and second embodiments described above deal with examples where a panel coloring paint film is formed on the surface of a protective panel and an antistatic paint film is formed over the surface of the panel coloring paint film, this is in no way intended to limit how the application is practiced; instead, an antistatic paint film may be given the same color as a panel coloring paint film so that the antistatic paint film is formed directly on the surface of a protective panel without forming a panel coloring paint film thereon.

Although the first and second embodiments described above deal with examples where an antistatic paint film is formed in a predetermined area on a panel coloring paint film formed on the surface of a protective panel, this is in no way intended to limit how the application is practiced; instead, an antistatic paint film may be formed all over except in a display window in a protective panel.

Although the first and second embodiments described above deal with examples where an antistatic paint is applied on the inner surface of a protective panel, this is in no way intended to limit how the application is practiced; instead, an antistatic paint may be applied on the outer surface of a protective panel.

Although the first and second embodiments described above deal with examples where an antistatic paint film on a protective panel and a grounded portion of a circuit board are connected together with screws and coil springs, respectively, this is in no way intended to limit how the application is practiced; instead, they may be connected together with any electrically conductive member other than screws or coil springs. For example, a contact spring may be, at one end, soldered to a circuit board and, at the other end, placed in contact with an antistatic paint film on a protective panel so that the antistatic paint film on the protective panel and a ground portion of the circuit board are connected together.

Although the first and second embodiments described above deal with examples where a grounded portion that is kept at the ground-side potential of a supplied electric power is provided on a circuit board, this is in no way intended to limit how the application is practiced; instead, a grounded portion may be provided elsewhere than on a circuit board.

Although the second embodiment deals with an example where coil springs are kept in contact with an antistatic paint film on a protective panel and also with a grounded portion of a circuit board, this is in no way intended to limit how the application is practiced; instead, coil springs may be simply placed close to an antistatic paint film and to a grounded portion.

## Claims

1. A portable electronic appliance for wireless communication,
comprising:
a casing (2, 3) containing a base board (4, 33) on which electronic components (3) are mounted, and
a protective panel (6) provided in a recess of the casing (2, 3),
wherein the surface of the protective panel (6) facing the inside of the appliance is painted with an antistatic paint film (10) that discharges static electricity but is electrically non-conductive for minimizing the change in the wireless communication characteristics of the electronic appliance, and
wherein electrically conductive members (7, 34) are provided for connecting the antistatic paint film (10) with grounded portions (4b, 33b) of the base board (4, 33), so that the electronic components (3) are protected from static electricity.

2. The electronic appliance according to claim 1,
comprising a display panel (5) for displaying information,
wherein the protective panel (6) is configured for protecting the display panel (5).

3. The electronic appliance according to claim 2,
wherein
as a result of the protective panel (6) being painted with the antistatic paint film (10), the protective panel (6) has formed thereon a discharge path for preferentially discharging static electricity, and
the discharge path is connected to or placed close to the electrically conductive member (7, 34).

4. The electronic appliance according to claim 2 or 3.
wherein
the antistatic paint film (10) comprises an electrically insulating base substance (10a) and an electrically conductive substance (10b), and
the antistatic paint film (10) is made electrically non-conductive as a result of the electrically conductive substance (10b) being discontinuously dispersed in the electrically insulating base substance (10a).

5. The electronic appliance according to claim 4.
wherein the antistatic paint film (10) contains a highest possible content of the electrically conductive substance (10b) within a range in which the antistatic paint film (10) remains electrically non-conductive.

6. The electronic appliance according to claim 4 or 5,
wherein the electrically conductive substance (10b) is a metal substance (10b).

## Patentansprüche

1. Tragbares elektronisches Gerät für drahtlose Datenübertragung,
mit:
einem Gehäuse (2, 3), das eine Grundplatte (4, 33) enthält, auf der elektronische Bauelemente (3) angebracht sind, und
einer Schutztafel (6), die in einer Ausnehmung in dem Gehäuse (2, 3) vorgesehen ist,
wobei die Oberfläche der Schutztafel (6), die zur Innenseite des Geräts weist, mit einer antistatischen Farbschicht (10) lackiert ist, die statische Elektrizität ableitet, jedoch elektrisch nicht leitend ist, wodurch die Änderung der Eigenschaften einer drahtlosen Datenübertragung des elektronischen Geräts minimiert wird, und
wobei elektrisch leitende Elemente (7, 34) vorgesehen sind, um die antistatische Farbschicht (10) mit geerdeten Abschnitten (4b, 33b) der Grundplatte (4, 33) zu verbinden, so dass die elektronischen Bauelemente (3) gegen statische Elektrizität geschützt sind.

2. Elektronisches Gerät nach Anspruch 1,
mit einer Anzeigetafel (5) zum Anzeigen von Informationen,
wobei die Schutztafel (6) zum Schützen der Anzeigetafel (5) eingerichtet ist.

3. Elektronisches Gerät nach Anspruch 2,
wobei
als ein Ergebnis, dass die Schutztafel (6) mit der antistatischen Farbschicht (10) lackiert ist, die Schutztafel (6) einen darauf ausgebildeten Entladungsweg aufweist, um vorzugsweise statische Elektrizität zu entladen, und
der Entladungsweg mit dem elektrisch leitenden Element (7, 34) verbunden oder nahe zu diesem angeordnet ist.

4. Elektronisches Gerät nach Anspruch 2 oder 3,
wobei
die antistatische Farbschicht (10) eine elektrisch isolierende Grundsubstanz (10a) und eine elektrisch leitende Substanz (10b) umfasst, und
die antistatische Farbschicht (10) als Ergebnis dessen, dass die elektrisch leitende Substanz (10b) in der elektrisch isolierenden Grundsubstanz (10a) diskontinuierlich verteilt ist, elektrisch nicht leitend hergestellt ist.

5. Elektronisches Gerät nach Anspruch 4,
wobei die antistatische Farbschicht (10) in einem Bereich, in dem die antistatische Farbschicht (10) elektrisch nichtleitend bleibt, einen höchstmöglichen Anteil der elektrisch leitenden Substanz (10b) enthält.

6. Elektronisches Gerät nach Anspruch 4 oder 5,
wobei die elektrisch leitende Substanz (10b) eine Metallsubstanz (10b) ist.

## Revendications

1. Appareil électronique portable destiné à des communications sans fil, comportant :
un boîtier (2, 3) contenant une carte de base (4, 33) sur laquelle sont montés des composants électroniques (3), et
un panneau de protection (6), placé dans un retrait du boîtier (2, 3),
dans lequel la surface du panneau de protection (6), située en opposition à la partie intérieure de l'appareil, est peinte avec un film de peinture antistatique (10) qui décharge l'électricité statique, mais qui est électriquement non conducteur, afin de minimiser le changement des caractéristiques de communication sans fil de l'appareil électronique, et
dans lequel des organes électriquement conducteurs (7, 34) sont mis en place pour relier le film de peinture antistatique (10) avec des parties reliées à la masse (4b, 33b) de la carte de base (4, 33), de sorte que les composants électroniques (3) soient protégés vis-à-vis de l'électricité statique.

2. Appareil électronique selon la revendication 1,
comportant un panneau d'affichage (5) destiné à afficher des informations,
dans lequel le panneau de protection (6) est configuré pour protéger le panneau d'affichage (5).

3. Appareil électronique selon la revendication 2,
dans lequel
suite à la peinture du panneau de protection (6) avec le film de peinture antistatique (10), le panneau de protection (6) porte un chemin de décharge destiné à décharger préférentiellement l'électricité statique, et
le chemin de décharge est relié à, ou placé à proximité de l'organe électriquement conducteur (7, 34).

4. Appareil électronique selon la revendication 2 ou 3,
dans lequel
le film de peinture antistatique (10) comporte une substance de base électriquement isolante (10a) et une substance électriquement conductrice (10b), et
le film de peinture antistatique (10) est rendu électriquement non conducteur suite à la dispersion discontinue de la substance électriquement conductrice (10b) dans la substance de base électriquement isolante (10a).

5. Appareil électronique selon la revendication 4,
dans lequel le film de peinture antistatique (10) contient une teneur maximale possible de la substance électriquement conductrice (10b) dans une plage dans laquelle le film de peinture antistatique (10) reste électriquement non conducteur.

6. Appareil électronique selon la revendication 4 ou 5,
dans lequel la substance électriquement conductrice (10b) est une substance métallique (10b).
